Europäisches Patentamt

European Patent Office

Office européen des brevets

(11) Veröffentlichungsnummer: **0 418 417 A1**

## (12) EUROPÄISCHE PATENTANMELDUNG

(21) Anmeldenummer: 89117473.2

(22) Anmeldetag: 21.09.89

(51) Int. Cl.5: **H03K 19/173**

Geänderte Patentansprüche gemäss Regel 86 (2) EPÜ.

(43) Veröffentlichungstag der Anmeldung:
27.03.91 Patentblatt 91/13

(84) Benannte Vertragsstaaten:
AT BE CH DE ES FR GB GR IT LI LU NL SE

(71) Anmelder: **Siemens Aktiengesellschaft**
**Wittelsbacherplatz 2**
**W-8000 München 2(DE)**

(72) Erfinder: **Hölzle, Josef, Dipl.-Ing. (FH)**
**Neubeuernerstrasse 11**
**W-8000 München 21(DE)**

(54) Schaltungsanordnung zur Generierung kombinatorischer binärer Logik mit Multiplexern und Invertern.

(57) Schaltungsanordnung zur Generierung kombinatorischer Logik durch Kaskadierung mehrerer Schaltungsblöcke, die jeweils aus einem 1 aus 4-Multiplexer (MUX) und einem Inverter (Z) bestehen, wobei die Steuereingänge (S1, S2) des Multiplexers (MUX) mit den höherwertigen Eingangsvariablen (A, B) beaufschlagt sind und die Dateneingänge abhängig von der realisierenden Verknüpfungsfunktion mit einer logischen Null, einer logischen Eins, der Eingangsvariablen mit niedrigster Wertigkeit (C) oder der invertierten Eingangsvariablen mit niedrigster Wertigkeit (C) beaufschlagt sind.

## FIG 1

# SCHALTUNGSANORDNUNG ZUR GENERIERUNG KOMBINATORISCHER BINÄRER LOGIK MIT MULTIPLE-XERN UND INVERTERN

Die Erfindung betrifft eine Schaltungsanordnung zur Generierung kombinatorischer binärer Logik mit Multiplexern und Invertern nach dem Oberbegriff des Patentanspruchs 1.

Schaltungsanordnungen zur Generierung kombinatorischer binärer Logik zählen zu den grundlegenden Schaltungen der Digitaltechnik und werden üblicherweise mit zweistufigen OR-AND- oder AND-OR-Gatteranordnungen oder mit Hilfe von Multiplexern und Invertern realisiert. Grundforderung für den Entwurf dieser Schaltungsanordnungen ist es, bei vertretbarem Zeitaufwand mit einem Minimum an Schaltelementen auszukommen. In der Regel werden zur Lösung des jeweiligen Problems entweder Minterme, d. h. Konjunktionen, oder Maxterme, d. h. Disjunktionen aller variablen herangezogen. Dabei benutzt man entweder diejenigen Minterme, die in der Sollfunktion eine logische 1 bewirken, oder diejenigen Maxterme, bei denen die Sollfunktion eine logische Null besitzt.

Möglichkeiten zur Minimierung des Schaltungsaufwandes bieten die Boolesche Algebra, die McCluskey-Methode oder die Karnaugh-Diagramme. Diese bekannten Methoden sind jedoch entweder schwierig handhabbar, zeitaufwendig oder auf eine bestimmte Anzahl von Eingangsvariablen beschränkt. Die Boolsche Algebra benutzt rein formale Methoden ohne System, die McCluskey-Methode ist zwar schematisch, aber umständlich und Karnaugh-Diagramme sind nur bis zu 5 Eingangsvariablen leicht handhabbar.

Daneben ist aus der EP-OS 0 176 938 eine Schaltungsanordnung bekannt, die mit Hilfe von Multiplexern und Invertern aus den Eingangsvariablen mit jeweils niedrigster Wertigkeit logische Grundfunktionen, denen gleich große Blöcke mit logischen Kombinationen entsprechen, generiert. Aus einer Kombination dieser Blöcke er geben sich die möglichen Ausgangszustände. Die Blöcke belegen die Dateneingänge einer Multiplexerschaltung und werden bei den Kombinationen der Eingangsvariablen, denen die logischen Kombinationen der Blöcke zugeordnet sind, zum Ausgang der Multiplexerschaltung durchgeschaltet. Dabei wird die Wahl des jeweils richtigen Blocks durch die Eingangsvariablen höherer Wertigkeit festgelegt, die die Steuereingänge der Multiplexerschaltung belegen.

Nachteil der bekannten Schaltungsanordnung ist, daß zur Generierung unterschiedlicher Logik, d. h. Schaltungsanordnungen mit unterschiedlicher Verknüpfungsfunktion zwischen den Eingangsvariablen und den Ausgangsvariablen, unterschiedliche Schaltungsstrukturen benötigt werden.

Aufgabe der Erfindung ist es daher, eine Schaltungsanordnung zur Generierung kombinatorischer binärer Logik anzugeben, bei der die Verknüpfungsfunktion ohne Änderung der Schaltungsstruktur einstellbar ist.

Die Aufgabe wird bei einer gattungsgemäßen Schaltungsanordnung durch die kennzeichnenden Merkmale des Patentanspruches 1 gelöst. Weiterbildungen des Erfindungsgedankens sind in Unteransprüchen gekennzeichnet.

Vorteile der Erfindung sind, neben der leicht handhabbaren und zeitunaufwendigen Einstellung der Verknüpfungsfunktion der Schaltungsanordnung, die Möglichkeit einer beliebigen, auch nachträglich veränderbaren und somit auch über Rechnersteuerung durchführbare Generierung kombinatorischer Logik sowie eine von der Verknüpfungsfunktion unabhängigen Signalverzögerungszeit der Schaltungsanordnung.

Die Erfindung wird nachfolgend anhand der in den Figuren der Zeichnung dargestellten Ausführungsbeispiele näher erläutert.

Es zeigt:
FIG 1 ein erstes Ausführungsbeispiel einer erfindungsgemäßen Schaltungsanordnung mit drei Eingangs- und einer Ausgangsvariablen,
FIG 2 ein zweites Ausführungsbeispiel einer erfindungsgemäßen Schaltungsanordnung mit drei Eingangsvariablen und zwei Ausgangsvariablen, und
FIG 3 ein drittes Ausführungsbeispiel einer erfindungsgemäßen Schaltungsanordnung mit vier Eingangsvariablen und einer Ausgangsvariablen.

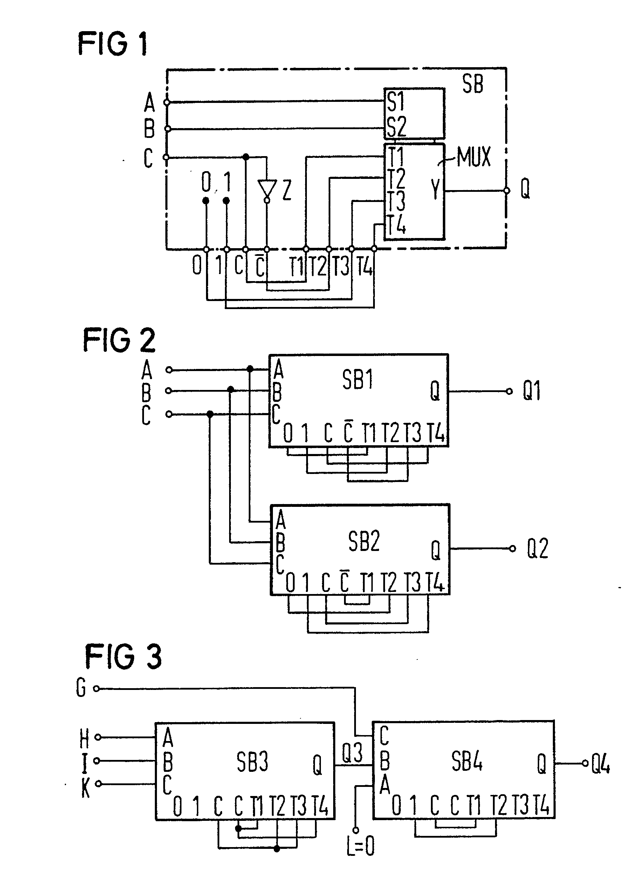

Eine erfindungsgemäße Schaltungsanordnung besteht, wie in FIG 1 der Zeichnung dargestellt, mindestens aus einem Schaltungsblock SB mit einem 1 aus 4-Multiplexer MUX und einem Inverter Z. Von drei Eingangsvariablen A, B, C sind die beiden höherwertigen Eingangsvariablen A, B an Steuereingänge S1 und S2 des Multiplexers MUX gelegt. Die Eingangsvariable C mit niedrigster Wertigkeit ist ebenso wie eine logische Null 0, eine logische Eins 1, sowie die durch den Inverter Z invertierte Eingangsvariable $\overline{C}$ mit niedrigster Wertigkeit, abhängig von der jeweils zu realisierenden Verknüpfungsfunktion, zur Beaufschlagung der Dateneingänge T1 bis T4 des Multiplexers MUX vorgesehen. Dabei wird jeweils der durch die Eingangsvariablen A, B mit höherer Wertigkeit ausgewählte Dateneingang T1 bis T4 mit einer logischen Null 0 beaufschlagt, wenn die den beiden Zuständen der Variablen C mit geringster Wertigkeit durch die Teilverknüpfungsfunktion zugeordneten Zustände der Ausgangsvariablen Q gleich Null sind, oder mit einer logischen Eins 1 beaufschlagt, wenn die den beiden möglichen Zuständen der Variablen C mit geringster Wertigkeit durch die Teilverknüpfungsfunktion zugeordneten Zustände der Ausgangsvariablen Q gleich Eins 1 sind, oder mit der Eingangsvariablen C mit geringster Wertigkeit beaufschlagt, wenn die den beiden Zuständen der Eingangsvariablen C mit geringster Wertigkeit durch die Teilverknüpfungsfunktion zugeordneten Zustände der Ausgangsvariablen Q gleich denen der Eingangsvariablen C mit geringster Wertigkeit sind, oder mit der invertierten Eingangsvariablen $\overline{C}$ mit geringster Wertigkeit beaufschlagt, wenn die den beiden möglichen Zuständen der Eingangsvariablen C mit geringster Wertigkeit durch die Teilverknüpfungsfunktion zugeordneten Zustände der Ausgangsvariablen Q gleich denen der invertierten Eingangsvariablen $\overline{C}$ mit geringster Wertigkeit sind.

In dem Ausführungsbeispiel gemäß FIG 1 ist die zu realisierende Verknüpfungsfunktion in Form einer Wertetabelle (Tabelle 1) gegeben.

| | A | B | C | Q | | |
|----|---|---|---|---|---|---|
| T1 | 0 | 0 | 0 | 0 | = | C |
| | 0 | 0 | 1 | 1 | | |
| T2 | 0 | 1 | 0 | 1 | = | $\overline{C}$ |
| | 0 | 1 | 1 | 0 | | |
| T3 | 1 | 0 | 0 | 0 | = | 0 |
| | 1 | 0 | 1 | 0 | | |
| T4 | 1 | 1 | 0 | 1 | = | 1 |
| | 1 | 1 | 1 | 1 | | |

Tabelle 1

Darin sind alle möglichen Kombinationen der Eingangsvariablen A, B, C, die für sich die Zustände Null 0 und Eins 1 annehmen können und die als Kombination einen Eingangszustand definieren, aufgelistet, wobei jedem Eingangszustand jeweils ein entsprechender Zustand der Ausgangsvariablen Q zugeordnet worden ist.

Da die Eingangsvariablen A, B mit höherer Wertigkeit jeweils einen Dateneingang T1 bis T4 des Multiplexers MUX auswählen, läßt sich die Wertetabelle in vier Bereiche einteilen, in denen jeweils einer der Dateneingänge T1 bis 74 zum Ausgang Y des Multiplexers MUX und damit zum Ausgang Q des Schaltungsblocks SB durchgeschaltet ist. In jedem dieser Bereiche treten bei der Variablen C mit niedrigster Wertigkeit die beiden Zustände Null 0 und Eins 1 auf. Dem zugeordnet sind die Zustände der Ausgangsvariablen Q, wobei es vier Möglichkeiten der Zuordnung gibt, nämlich daß deren Zustände gleich der Zustände der Eingangsvariablen C niedrigster Wertigkeit sind, daß sie gleich der Zustände der invertierten Eingangsvariablen $\overline{C}$ mit niedrigster Wertigkeit sind, daß sie in beiden Fällen gleich Null 0 oder daß sie in beiden Fällen gleich Eins 1 sind. Werden nun die jeweils ausgewählten Dateneingänge mit den daraus gewonnenen Konstanten bzw. Variablen beaufschlagt, so generiert der Schaltungsblock SB Logik mit einer durch die Wertetabelle (Tabelle 1) festgelegten Verknüpfungsfunktion. Im vorliegenden Ausführungsbeispiel wird also gemäß Tabelle 1 an den Dateneingang T1 die Eingangsvariable mit geringster Wertigkeit, an den Dateneingang T2 die invertierte Eingangsvariable $\overline{C}$ mit geringster Wertigkeit, an den Dateneingang T3 die konstante Null 0 und an den Dateneingang T4 die konstante Eins 1 angelegt.

Zur Realisierung von Verknüpfungsfunktionen mit mehr als drei Eingangsvariablen und mehr als einer Ausgangsvariablen wird erfindungsgemäß die Verknüpfungsfunktion in mehrere Teilverknüpfungsfunktionen mit drei Eingangsvariablen und einer Ausgangsvariablen aufgeteilt. Bei einer Erhöhung der Zahl der Ausgangsvariablen wird dazu die entsprechende Anzahl von Schaltungsblöcken SB eingangsseitig parallel geschaltet. Das Ausführungsbeispiel gemäß FIG 2 zeigt eine Schaltungsanordnung mit drei Eingangs- und zwei Ausgangsvariablen. Zwei Schaltungsblöcke SB1 und SB2 mit einem zum Schaltungsblock SB identischen Aufbau sind eingangsseitig mit den Eingangsvariablen A, B, C beaufschlagt. Die Wertetabelle (Tabelle 2) der zu realisierenden Verknüpfungsfunktion ist dazu in zwei Wertetabellen mit je drei Eingangsvariablen aufzuteilen, die dann jeweils durch einen Schaltungblock SB1, SB2 mit den Eingangsvariablen A, B, C und den Ausgangsvariablen Q1, Q2 realisiert werden.

|    | A | B | C | Q1 | (SB1) | Q2 | (SB2) |
|----|---|---|---|----|-------|----|-------|
| T1 | 0 | 0 | 0 | 0 | | 1 | |
| | 0 | 0 | 1 | 0 | $= 0$ | 0 | $= \bar{C}$ |
| T2 | 0 | 1 | 0 | 1 | | 0 | |
| | 0 | 1 | 1 | 1 | $= 1$ | 0 | $= 0$ |
| T3 | 1 | 0 | 0 | 1 | | 1 | |
| | 1 | 0 | 1 | 0 | $= \bar{C}$ | 0 | $= C$ |
| T4 | 1 | 1 | 0 | 0 | | 1 | |
| | 1 | 1 | 1 | 1 | $= C$ | 1 | $= 1$ |

Tabelle 2

Daraus ergibt sich, daß beim Schaltungsblock SB1 der Eingang T1 mit der konstanten Null 0, der Eingang T2 mit der konstanten Eins 1, der Dateneingang T3 mit der Variablen $\bar{C}$ und der Dateneingang T4 mit der Eingangsvariablen & beaufschlagt ist. Bei dem zweiten Schaltungsblock SB2 ist der Eingang T1 mit der Eingangsvariablen $\bar{C}$, der Eingang T2 mit der konstanten Null 0, der Eingang T3 mit der Eingangsvariablen C und der Eingang T4 mit der konstanten Eins 1 beaufschlagt.

Zur Erhöhung der Zahl der Eingangsvariablen werden diese jeweils in Dreiergruppen aufgeteilt und dann jeweils einem Schaltungsblock zugeführt. Die Ausgänge der Schaltungsblöcke werden wiederum in Dreiergruppen aufgeteilt und weiteren Schaltungsblöcken zugeführt bzw. weitere bei der Dreiergruppenbildung überschüssige Eingangs- und Ausgangsvariable zu Dreiergruppen zusammengefaßt und Schaltungsblöcken zugeführt. Das Ausführungsbeispiel gemäß FIG 3 zeigt eine Schaltungsanordnung mit vier Eingangsvariablen G, H, I, K sowie einer Ausgangsvariablen Q4. Die Wertetabelle (Tabelle 3) der zu realisierenden Verknüpfungsfunktion ist dazu in eine Dreiergruppe mit den drei Eingangsvariablen H, I, K sowie der verbleibenden Eingangsvariablen G aufgeteilt, wobei die Dreiergruppe einem Schaltungsblock SB3 zugeführt wird. Die verbleibende Eingangsvariable G ist mit der Ausgangsvariablen Q3 des Schaltungsblockes SB3 und einer weiteren Eingangsvariablen L zu einer Dreiergruppe zusammengefaßt, die an einen Schaltungsblock SB4 angelegt ist. Die weitere Eingangsvariable L wird dabei gleich Null 0 gesetzt. Als Verknüpfungsfunktion der Eingangsvariablen L und G sowie der Ausgangsvariablen Q3 im Schaltungsblock SB4 wird beispielsweise eine Oder-Verknüpfung vorgegeben, die entsprechend Tabelle 4 eine Beschaltung des Schaltungsblockes SB4 zur Folge hat, der Gestalt, daß der Eingang T1 mit der Eingangsvariablen C und der Dateneingang T2 mit der Konstanten Eins 1 beaufschlagt ist. Da die Eingangsvariable L gleich Null gesetzt ist werden die Dateneingänge T3 und T4 nicht durchgeschaltet. Durch Abspalten der Eingangsvariablen G in Tabelle 3 ergibt sich ein Zusammenhang gemäß Tabelle 5.

| G | H | I | K | Q4 | – | Q3 |
|---|---|---|---|----|---|----|
| 0 | 0 | 0 | 0 | 1 | | 1 |
| 0 | 0 | 0 | 1 | 0 | | 0 |
| 0 | 0 | 1 | 0 | 0 | | 0 |
| 0 | 0 | 1 | 1 | 1 | | 1 |
| 0 | 1 | 0 | 0 | 0 | | 0 |
| 0 | 1 | 0 | 1 | 1 | | 1 |
| 0 | 1 | 1 | 0 | 1 | | 1 |
| 0 | 1 | 1 | 1 | 0 | | 0 |
| 1 | 0 | 0 | 0 | 0 | | 1 |
| 1 | 0 | 0 | 1 | 1 | | 0 |
| 1 | 0 | 1 | 0 | 1 | | 0 |
| 1 | 0 | 1 | 1 | 0 | | 1 |
| 1 | 1 | 0 | 0 | 1 | | 0 |
| 1 | 1 | 0 | 1 | 0 | | 1 |
| 1 | 1 | 1 | 0 | 0 | | 1 |
| 1 | 1 | 1 | 1 | 1 | | 0 |

Tabelle 3

| | L | Q3 | G | Q4 | (SB4) |
|----|---|----|---|----|-------|
| T1 | 0 | 0 | 0 | 0 | G |
| | 0 | 0 | 1 | 1 | |
| T2 | 0 | 1 | 0 | 1 | 1 |
| | 0 | 1 | 1 | 1 | |

Tabelle 4

| | H | I | K | Q3 | (SB3) |
|----|---|---|---|----|-------|
| T1 | 0 | 0 | 0 | 1 | = $\overline{R}$ |
| | 0 | 0 | 1 | 0 | |
| T2 | 0 | 1 | 0 | 0 | K |
| | 0 | 1 | 1 | 1 | |
| T3 | 1 | 0 | 0 | 0 | K |
| | 1 | 0 | 1 | 1 | |
| T4 | 1 | 1 | 0 | 1 | $\overline{R}$ |
| | 1 | 1 | 1 | 0 | |

Tabelle 5

Daraus ergibt sich für den Schaltungsblock SB3, daß die Dateneingänge T1 und T4 mit der Eingangsvariablen C und die Eingänge T2 und T3 mit der Eingangsvariablen & beaufschlagt sind. Die Schaltungsblöcke SB3 und SB4 sind erfindungsgemäß ebenfalls im Aufbau identisch zum Schaltungsblock SB.

Abschließend sei darauf hingewiesen, daß durch Parallel- und Reihenschaltung Verknüpfungen von einer beliebigen Anzahl von Eingangsvariablen mit einer beliebigen Anzahl von Ausgangsvariablen möglich ist.

## Ansprüche

Schaltungsanordnung zur Generierung kombinatorischer binärer Logik mit Multiplexern und Invertern, die bei jedem durch eine Kombination von Eingangsvariablen definierten Eingangszustand, einen durch eine Verknüpfungsfunktion eindeutig festgelegten, durch mindestens eine Ausgangsvariable definierten Ausgangszustand besitzt und bei der die Verknüpfungsfunktion aus einer oder mehreren Teilverknüpfungsfunktionen, denen jeweils Schaltungsblöcke entsprechen, zusammengesetzt ist,
**dadurch gekennzeichnet,** daß die Schaltungsblöcke (SB, SB1...SB4) jeweils zur Verknüpfung von drei Eingangsvariablen (A, B, C) mit einer Ausgangsvariablen (Q) vorgesehen sind,
daß ein Schaltungsblock (SB, SB1.. .SB4) aus einem 1 aus 4-Multiplexer (MUX) und einem Inverter (Z) besteht,
daß die beiden Steuereingänge (S1, S2) des Multiplexers (MUX) mit den Eingangsvariablen (A, B) mit höherer Wertigkeit beaufschlagt sind,
daß jeweils der durch die Eingangsvariablen (A, B) mit höherer Wertigkeit ausgewählte Dateneingang (T1...T4) des Multiplexers (MUX) mit einer logischen Null (0) beaufschlagt ist, wenn die den beidden möglichen Zuständen der Variablen (C) mit geringster Wertigkeit durch die Teilverknüpfungsfunktion zugeordneten Zustände der Ausgangsvariablen (Q) gleich Null sind,
oder mit einer logischen Eins 1 beaufschlagt ist, wenn die den beiden möglichen Zuständen der Variablen (C) mit geringster Wertigkeit durch die Teilverknüpfungsfunktion zugeordneten Zustände der Ausgangsvariablen (Q) gleich 1 sind,
oder mit der Eingangsvariablen (C) mit geringster Wertigkeit beaufschlagt, wenn die den beiden Zuständen der Eingangsvariablen (C) mit geringster Wertigkeit durch die Teilverknüpfungsfunktion zugeordneten Zustände der Ausgangsvariablen (Q) gleich denen der Eingangsvariablen (C) mit geringster Wertigkeit sind oder
mit der invertierten Eingangsvariablen ( $\overline{C}$ ) mit geringster Wertigkeit beaufschlagt ist, wenn die den beiden möglichen Zuständen der Eingangsvariablen (C) mit geringster Wertigkeit durch die Teilverknüpfungsfunktion zugeordneten Zustände der Ausgangsvariablen (Q) gleich denen der invertierten Eingangsvariablen ( $\overline{C}$ ) mit geringster Wertigkeit zählt.

Geänderte Patentansprüche gemäss regel 86(2) EPÜ.

Schaltungsanordnung zur Generierung kombinatorischer binärer Logik mit Multiplexern und Invertern, die bei jedem durch eine Kombination von Eingangsvariablen definierten Eingangszustand, einen durch eine Verknüpfungsfunktion eindeutig festgelegten, durch mindestens eine Ausgangsvariable definierten Ausgangszustand besitzt und bei der die Verknüpfungsfunktion aus einer oder mehreren Teilverknüpfungsfunktionen, denen jeweils Schaltungsblöcke entsprechen, zusammengesetzt ist, wobei ein Schaltungsblöcke (SB, SB1,..,SB4) zur Verknüpfung von drei Eingangsvariablen (A, B, C) mit einer Ausgangsvariablen (Q) vorgesehen ist, der aus einem 1 aus 4-Multiplexer (MUX) und einem Inverter (Z) besteht, bei dem die beiden Steuereingänge (S1, S2) des Multiplexers (MUX) mit den Eingangsvariablen (A, B) mit höherer Wertigkeit beaufschlagt sind, bei dem der durch die Eingangsvariablen (A, B) mit höherer Wertigkeit ausgewählte Dateneingang (T1...T4) des Multiplexers (MUX) mit einer logischen Null (0) beaufschlagt ist, wenn die den beiden möglichen Zuständen der Variablen (C) mit geringster Wertigkeit durch die Teilverknüpfungsfunktion zugeordneten Zustände der Ausgangsvariablen (Q) gleich Null sind, oder mit einer logischen Eins 1 beaufschlagt ist, wenn die den beiden möglichen Zuständen der Variablen (C) mit geringster Wertigkeit durch die Teilverknüpfungsfunktion zugeordneten Zustände der Ausgangsvariablen (Q) gleich 1 sind, oder mit der Eingangsvariablen (C) mit geringster Wertigkeit beaufschlagt, wenn die den beiden Zuständen der Eingangsvariablen (C) mit geringster Wertigkeit durch die Teilverknüpfungsfunktion zugeordneten Zustände der Ausgangsvariablen (Q) gleich denen der Eingangsvariablen (C) mit geringster Wertigkeit sind oder mit der invertierten Eingangsvariablen ( $\overline{C}$ ) mit geringster Wertigkeit beaufschlagt ist, wenn die den beiden möglichen Zuständen der Eingangsvariablen (C) mit geringster Wertigkeit durch die Teilverknüpfungsfunktion zugeorneten Zustände der Ausgangsvariablen (Q) gleich denen der invertierten Eingangsvariablen ($\overline{C}$) mit geringster Wertigkeit sind, **dadurch gekennzeichnet,** daß bei mehr als drei Eingangsvariablen (A,B,C,D...) bzw. mehr als einer Ausgangsvariablen (Q1,Q2) jeweils gleiche Schaltungsblöcke (SB1,SB2;SB3,SB4) vorgesehen sind, die bei drei Eingangsvariablen (A,B,C) und mehreren Ausgangsvariablen (Q1,Q2) eingangsseitig parallelgeschaltet sind, von denen bei mehr als drei Eingangsvariablen (G,H,I,K) und einer Ausgangsvariablen (Q4) ein erster Teil der Schaltungsblöcke (SB3) von jeweils drei Eingangsvariablen (H,I,K) und ein weiterer Teil der Schaltungsblöcke (SB4) von Ausgängen (Q3) des ersten Teils der Schaltungsblöcke (SB3) bzw. von überschüssigen Eingangsvariablen (G) beaufschlagt wird und die bei mehr als drei Eingangsvariablen und mehr als einer Ausgangsvariablen entsprechend durch Parallelschalten mehrerer erster und weiterer Teile der Schaltungsblöcke (SB1 bis SB4) verbunden sind.

**FIG 1**

**FIG 2**

**FIG 3**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | ELECTRONICS INTERNATIONAL, Band 50, Nr. 9, April 1977, Seiten 120-121, New York, US; J.E. SIEBERT: "Digital multiplexers reduce chip count in logic design" <br> * Figur 2; Seite 120, rechter Spalte, Zeile 17 - Seite 121, linker Spalte, Zeile 5 * <br> ----- | 1 | H 03 K 19/173 |

| | RECHERCHIERTE SACHGEBIETE (Int. Cl.5) |
|---|---|
| | H 03 K |

Der vorliegende Recherchenbericht wurde für alle Patentansprüche erstellt

| Recherchenort | Abschlußdatum der Recherche | Prüfer |
|---|---|---|
| DEN HAAG | 18-05-1990 | FEUER F.S. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.......................................................................
& : Mitglied der gleichen Patentfamilie, übereinstimmendes Dokument